# EUROPÄISCHE PATENTSCHRIFT

(11) **EP 1 651 378 B1**
(45) Veröffentlichungstag und Bekanntmachung des Hinweises auf die Patenterteilung: **14.12.2011**
(21) Anmeldenummer: 04766382.8
(22) Anmeldetag: 30.07.2004
(51) Int. Cl.: B23K 1/00

(54) **VERFAHREN ZUM NON-VAKUUM-ELEKTRONENSTRAHLSCHWEISSEN VON METALLISCHEN WERKSTOFFEN**
METHOD FOR NON-VACUUM ELECTRON BEAM WELDING METALLIC MATERIALS
PROCEDE POUR SOUDER PAR FAISCEAUX D'ELECTRONS SANS VIDE DES MATERIAUX METALLIQUES

(30) Priorität: 04.08.2003 DE 10336136; 04.08.2003 DE 10336134; 04.08.2003 DE 10336135; 31.10.2003 DE 10351901; 13.05.2004 DE 102004023684; 13.05.2004 DE 102004023685; 15.05.2004 DE 102004024238; 29.05.2004 DE 102004026473; 29.05.2004 DE 102004026474
(43) Veröffentlichungstag der Anmeldung: 03.05.2006
(73) Patentinhaber: Air Liquide Deutschland GmbH, 47793 Krefeld (DE); Messer Group GmbH, 65812 Bad Soden am Taunus (DE)
(72) Erfinder: HILDEBRANDT, Bernd, 47918 Tönisvorst (DE); WANKUM, Achim, 47809 Krefeld (DE)
(74) Vertreter: Münzel, Joachim R.
(86) Internationale Anmeldenummer: PCT/EP2004/051674
(87) Internationale Veröffentlichungsnummer: WO 2005/011907

(56) Entgegenhaltungen:
- DE-A1- 10 157 403
- DE-A1- 19 526 324
- US-A- 3 393 289
- US-A- 3 585 348
- US-A- 4 304 979
- PATENT ABSTRACTS OF JAPAN Bd. 006, Nr. 144 (E-122), 3. August 1982 (1982-08-03) & JP 57 065661 A (TOSHIBA CORP), 21. April 1982 (1982-04-21)
- "Schutzgase zum lichtbogenschweissen und schneiden" DIN EN 439, XX, XX, 1998, Seiten 192-196, XP002274674

## Beschreibung

Die Erfindung betrifft ein Verfahren zum Non - Vakuum-Elektronenstrahlschweißen von metallischen Werkstoffen mit einer Vakuum-Elektronenstrahl-Kanone unter Einsatz von Prozessgas nach dem Oberbegriff des Anspruch 1. Ein solches Verfahren ist aus der JP57065661 bekannt.

Beim bekannten Non - Vakuum - Elektronenstrahlschweißen von metallischen Werkstoffen wird ein Elektronenstrahl aus einer Vakuum-Elektronenkanone heraus auf ein zu bearbeitendes Werkstück emittiert, ohne das das Werkstück dabei in einem Schutzvakuum vorliegt. Um insbesondere elektromagnetische Einflüsse der Umgebungsatmosphäre auf den Elektronenstrahl, die zu einer raschen Aufweitung des Strahls führen würden, zu unterbinden, wird nach dem Stande der Technik ein Prozessgas konzentrisch zum Elektronenstrahl eingedüst. Aus diesem Grunde wurde bislang Helium als bevorzugtes Prozessgas eingesetzt, das keinerlei elektrische Einflüsse auf den Elektronenstrahl ausübt.

Helium steht jedoch nur begrenzt zur Verfügung und ist somit in der Anwendung relativ teuer. Zudem führt Helium beim bekannten Non - Vakuum - Elektronenstrahlschweißen zu fertigungstechnischen Nachteilen in Form starker Kerbbildung am Schweißnahtrand und wellenförmigen Unregelmäßigkeiten entlang der Schweißnaht. Weiterhin besteht nur eine ungenügende Schutzgaswirkung gegenüber auf den Schmelzbereich einwirkenden atmosphärischen Störeinflüssen, da das Prozessgas beim Einsatz rasch fast vollständig vom Vakuum in der Elektronenstrahl-Kanone aufgesogen wird. Schließlich kommt es auf Grund des vergleichsweise kleinen Schmelzbades und der hohen Schweißgeschwindigkeiten beim Non - Vakuum - Elektronenstrahlschweißen bei den mit dem Abkühlprozess einhergehenden Schrumpfungen zu starken Nahtüberhöhungen in der Nahtmitte und Einbrandkerben im Nahtseitenbereich. Die Festigkeitseigenschaften der Naht werden dadurch stark beeinträchtigt. Eine Beeinflussung des Schmelzbades, die diese Nachteile beseitigen könnten, ist mit dem bekannten Schweißverfahren nicht möglich.

Der Erfindung liegt somit die Aufgabe zugrunde, ein Verfahren zum Non - Vakuum-Elektronenstrahlschweißen von metallischen Werkstoffen zur Verfügung zu stellen, mit welchem eine kostengünstige und zudem qualitätsgerechte Werkstoffbearbeitung möglicht ist.

Die Aufgabe wird erfindungsgemäß durch ein Verfahren mit den Merkmalen von Anspruch 1 gelöst.

Durch das beim erfindungsgemäßen Non - Vakuum - Elektronenstrahlschweißen zusätzlich und unabhängig zum Prozessgas eingesetzte, dem Schweißbereich zugeführte Schutzgas werden atmosphärische Störeinflüsse im Schweißbereich des Schweißguts während des Schweißens, insbesondere der Luftzutritt in den Schweißbereich des zu schweißenden Werkstoffs verhindert bzw. derart verringert, dass eine die Schweißqualität herabsetzende Oxidation der Schweißnahtoberfläche, auch nach Abschluss des eigentlichen Schweißvorgangs, ausgeschlossen wird. Insbesondere wird durch die erfindungsgemäße Schutzgaszuführung beim Non - Vakuum - Elektronenstrahlschweißen von metallischen Werkstoffen das äußere Schweißnahtbild, die Nahtgeometrie sowie die qualitativen Eigenschaften, wie z.B. der Porenanteil der Schweißnaht und damit die Schweißqualität, positiv beeinflusst.

Das als Sekundärgas eingesetzte Schutzgas wird gleichzeitig mit dem Prozessgas eingesetzt, kann aber auch als ein dem Prozessgas zeitlich vor- und nachströmendes Schutzgas eingesetzt werden. Die Einsatzmenge, die Temperatur, Druck und die jeweilige Zusammensetzung des Schutzgases kann dabei entsprechend den jeweiligen Verfahrensbedingungen gewählt werden. Insbesondere können Schutzgas und Prozessgas unterschiedliche Zusammensetzung, Temperatur, Druck, etc. haben.

Das Prozessgas wird als ein den Elektronenstrahl umhüllender Prozessgasstrahl und das Schutzgas als ein den Prozessgasstrahl umhüllender Schutzgasstrahl eingesetzt. Mit dieser konzentrischen Ausführung können die Volumenströme des Prozessgases und des Schutzgases hinsichtlich Menge, Zeit und Kontinuität den unterschiedlichen Schweißbedingungen problemlos angepasst werden.

Das Schutzgas kann zweckmäßiger Weise kontinuierlich oder pulsweise dem Schweißbereich zugeführt werden.

Es findet beim erfindungsgemäßen Non-Vakuum-Elektronenstrahlschweißen von Aluminiumwerkstoffen ein Schutzgas Verwendung, das Argon und Helium enthält. Gleichfalls vorteilhaft sind Bestandteile von Sauerstoff und/oder Stickstoff, wobei besonders vorteilhaft als Schutzgas ein Gasgemisch eingesetzt wird, das 10 bis 90 Vol.-% Helium und/oder 0,01 bis 75 Vol.-% Stickstoff und/oder 0,02 - 25 Vol.-% Sauerstoff, Rest jeweils Argon, enthält.

Mit dem Prozessgas, das aus Helium und einem Stickstoffanteil, der 40 bis 80 Vol.-% beträgt, besteht, lässt sich das Nahtprofil ganz gezielt beeinflussen und die Ausbildung von Schweißnahtrandkerben weiter wesentlich minimieren. Durch den Stickstoffanteil im Prozessgas wird zudem eine Verbreiterung des Schweißnahtprofils und damit eine besserer Überbrückung größerer Bauteiltoleranzen möglich. Durch das im erfindungsgemäßen Prozessgas enthaltene Helium wird der erforderliche Tiefschweißeffekt gewährleistet. Besonders vorteilhaft ist ein Helium-Stickstoff-Prozessgas mit einer Beimischung von bis zu 20 Vol.-% Wasserstoff und/oder von bis zu 25 Vol.-% Sauerstoff einsetzbar. Das erfindungsgemäße Prozessgas ist auch ohne Einsatz von Schutzgas einsetzbar.

Der Einsatz der vorgenannten bevorzugten Schutz- und Prozessgase beim erfindungsgemäßen Verfahren zum Non - Vakuum-Elektronenstrahlschweißen ermöglicht eine besonders kostengünstige und qualitätsgerechte Bearbeitung von metallischen Werkstoffen.

Eine weitere Verbesserung kann dadurch erzielt werden, dass ein Verfahren zum Non -Vakuum- Elektronenstrahlschweißen mit einem mitlaufenden, d.h. im Schmelzbad des zu schweißenden Werkstoffs und weitgehend zeitgleich mit dem Schweißprozess erfolgenden, oder mit einem nachlaufenden, also mit einem in zwei getrennten Schmelzbädern und nicht zeitgleich mit dem Schweißprozess stattfindenden, Aufschmelzprozess kombiniert wird. Dadurch werden beim Abkühlprozess nach dem Schweißvorgang etwaig auftretende Nahtfehler, insbesondere Nahtüberhöhungen in der Nahtmitte und Einbrandkerben im Nahtseitenbereich, ausgeglichen und somit die Nahtgeometrie günstig beeinflusst. Dies wird dadurch bewirkt, dass die beim Schweißprozess in der Schweißnahtmitte auftretenden Werkstoffanhäufungen aufgeschmolzen und zum Auffüllen des in den Seitenbereichen der Schweißnaht vorhandenen Fehlbereichs Verwendung finden. Die Festigkeitseigenschaften der Schweißnaht wird dadurch wesentlich verbessert. Zweckmäßigerweise kommt für den Aufschmelzprozess ein Schweißverfahren, wie z.B. eines herkömmlichen WIG-, Plasma- oder Laserschweißverfahren zum Einsatz.

Danach umfasst eine Vorrichtung zur Durchführung des Non-Vakuum-Elektronenstrahlschweißens neben einer Vakuum - Elektronenstrahlkanone und einer Einrichtung zum Zuführen von Prozessgas eine Schutzgaszuführung.

Zweckmäßigerweise sind die Einrichtung zum Zuführen von Prozessgas und die Schutzgaszuführung strömungstechnisch voneinander getrennt, um die Einleitung jeweils unterschiedlicher Gasgemische mit unterschiedlichen physikalischen Parametern zuzulassen.

In einer bevorzugten Ausgestaltung umfasst die Schutzgaszuführung eine im Bereich des Schweißkopfes der Vakuum-Elektronenstrahl-Kanone angeordnete Düsenkonfiguration. Die vorteilhaft auch eine kontinuierliche oder gepulste Schutzgaszuführung ermöglichende Düsenkonfiguration ist in Arbeitsrichtung der Vakuum-Elektronenstrahlkanone beweglich angeordnet. Dem aus der Vakuum-Elektronenstrahl-Kanone durch mindestens eine Öffnung in die Düsenkonfiguration eingeleiteten und von einem Prozessgasstrahl umhüllten Elektronenstrahl wird wenigstens ein, durch eine mit einer Versorgung verbundene Zuleitung in die Düsenkonfiguration eingeleitetes Schutzgas zugeführt und - zusammen mit dem Elektronenstrahl - durch mindestens eine Öffnung der Düsenkonfiguration auf das zu schweißende Werkstück geleitet, wobei der Elektronenstrahl bevorzugt konzentrisch durch die Öffnung geführt wird. Hierdurch wird ein von atmosphärischen Störeinflüssen freier Schweißbereich gewährleistet.

Als Alternative oder Ergänzung zur vorgenannten Düsenkonfiguration umfasst die Schutzgaszuführung vorteilhaft ein an einer Gaszuleitung angeschlossenes und in Richtung auf das zu bearbeitende Werkstück gerichtetes Gasrohr, das winkelverstellbar, stechend oder schleppend angestellt ist. Dabei wird das Schutzgas bei einer Schutzgaszuführung mit schleppendem Anstellwinkel dem Schweißbereich entgegengesetzt der Schweißrichtung (Arbeitsrichtung der Elektronenstrahl-Kanone) und bei einer Schutzgaszuführung mit stechendem Anstellwinkel dem Schweißbereich in Schweißrichtung (Arbeitsrichtung der Elektronenstrahl-Kanone) zugeführt. Um die Schweißgaszuführung den jeweiligen Prozessbedingungen optimal anzupassen, ist der Anstellwinkel variabel. Auch der Einsatz mehrerer, den Schweißbereich aus verschiedenen Richtungen mit dem gleichen oder jeweils unterschiedlichem Schutzgas belegenden Gasrohren ist im Rahmen der Erfindung möglich.

Durch Versuche wurde ermittelt, dass mit Düsenkonfigurationen, deren Elektronenstrahl-Austrittsöffnung/en einen Durchmesser von 1 bis 50 mm aufweisen, besonders gute Schweißergebnisse erzielt werden. Die zur Schutzgaszuführung bei dem erfindungsgemäßen Verfahren zum Non - Vakuum - Elektronenstrahlschweißen eingesetzte Düsenkonfiguration ist jedoch in ihren Abmessungen an die jeweiligen schweißtechnischen Gegebenheiten und den Abmessungen der Elektronenstrahl-Kanone anpassbar.

Das Schutzgas wird mittels einer im Bereich des aus der Vakuum-Elektronenstrahlröhre in Richtung des zu schweißenden Materials austretenden Elektronenstrahls angeordneten, vorteilhaft in Arbeitsrichtung beweglichen Schutzgaszuführung dem Schweißbereich des zu schweißenden Materials während des Schweißprozesses in unterschiedlicher Zeitfolge und Menge zugeführt.

Anhand der Zeichnungen sollen nachfolgend Ausführungsbeispiele der Erfindung näher erläutert werden. In schematischen Ansichten zeigen:
Fig. 1: Eine Vakuum-Elektronenstrahl-Kanone mit einer Schutzgaszuführung in einer ersten Ausführungsform,
Fig. 2: Eine Vakuum-Elektronenstrahl-Kanone mit einer Schutzgaszuführung in einer zweiten Ausführungsform,

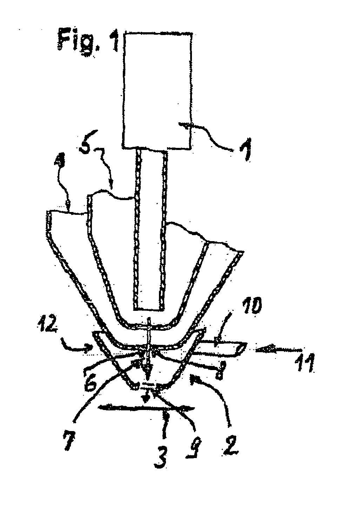

Fig. 1 zeigt eine Vorrichtung mit einer Vakuum-Elektronenstrahl-Kanone 1 und einer Schutzgaszuführung 2, die im Bereich des Schweißkopfes der Vakuum-Elektronenstrahl-Kanone 1 angeordnet ist.

Die in Arbeitsrichtung 3 bewegliche Vakuum-Elektronenstrahl-Kanone 1 weist im Ausführungsbeispiel zwei, zur Abdichtung gegenüber der Atmosphäre ausgebildete Unterdruckstufen 4, 5 und eine Austrittsöffnung 6 für einen Elektronenstrahl 7 auf. Die Vakuum - Elektronenstrahl-Kanone 1 weist des weiteren im Bereich der Mündungsöffnung 6 eine an sich bekannte und daher hier nicht gezeigten Prozessgaszuführung auf. Die Prozessgaszuführung umfasst eine konzentrisch um den Elektronenstrahl angeordnete Ausströmöffnung, aufgrund der der Elektronenstrahl beim Einsatz der Elektronenstrahl-Kanone von einem Prozessgasstrahl eingeschlossen ist und dadurch von störenden elektromagnetischen Einflüssen des Schutzgases oder der Außenatmosphäre geschützt wird. Als Prozessgas kommt insbesondere ein Gasgemisch aus Helium und 40-80 Vol-% Stickstoff, ein Gasgemisch aus Helium und bis zu 20 Vol-% Wasserstoff oder ein Gemisch aus Helium, Stickstoff und bis zu 20% Wasserstoff und bis zu 25% Sauerstoff in Betracht.

Die beim Ausführungsbeispiel in Fig. 1 gleichfalls im Bereich der Öffnung 6 der Vakuum-Elektronenstrahl-Kanone 1, beispielsweise um die Prozessgasführung herum oder unterhalb von dieser, angeordnete Schutzgaszuführung 2 ist als Düsenkonfiguration 2 ausgebildet und weist eine Eintritts- und Austrittsöffnung 8, 9 für den Elektronenstrahl 7 sowie eine Zuleitung 10 für ein Schutzgas 11 auf. Die Austrittsöffnung 9 dient zugleich der Zuführung des Schutzgases an das (im Bild nicht gezeigte) Werkstück. Die Austrittsöffnung 9 ist dabei ebenfalls konzentrisch um den Elektronenstrahl angeordnet, weist jedoch einen größeren Öffnungsdurchmesser als die Ausströmöffnung der Prozessgaszuführung auf.

Als Schutzgas kommt insbesondere ein Argon-Helium-Gemisch oder ein Argon und Helium enthaltendes Gasgemisch, das zusätzlich die Komponenten Stickstoff und/oder Sauerstoff enthält, zum Einsatz. Da die Gaszuführungen für das Prozessgas und das Schutzgas strömungstechnisch voneinander getrennt sind, kann das Schutzgas die gleiche Zusammensetzung wie das Prozessgas enthalten, oder sich von diesem in Bezug auf seine Zusammensetzung oder seiner physikalischen Parameter, wie Druck oder Temperatur, unterscheiden.

Dem durch die Öffnung 6 aus der Vakuum-Elektronenstrahl-Kanone 1 durch die Öffnung 8 in die Düsenkonfiguration 12 eingeleiteten und von einem Prozessgasstrahl umhüllten Elektronenstrahl 7 wird ein durch die Zuleitung 10 in die Düsenkonfiguration 2 eingeströmtes Schutzgas 11 zugeführt und der von dem Schutzgas 11 umströmte bzw. umhüllte Elektronenstrahl 7 durch die Öffnung 9 der Düsenkonfiguration 2 auf die Oberfläche eines zu schweißenden Werkstücks geleitet.

Durch Schweißversuche wurde ermittelt, dass Düsenkonfigurationen 2, die ein oder mehrere Auströmöffnung/en 9 mit einen Durchmesser von 1 bis 50 mm aufweisen, zur variablen Einstellung des Schutzgases 11 hinsichtlich Menge, Zeit und Kontinuität sowie besonders vorteilhaft, auch zur kontinuierlichen oder gepulsten Schutzgaszuführung, einsetzbar sind.

Die an die Vakuum-Elektronenstrahl-Kanone 1 angeordnete und somit auch in deren Arbeitsrichtung 3 bewegliche Düsenkonfiguration 2 besteht aus einem kostengünstigen und gasresistenten Material und ist an unterschiedliche Schweißbedingungen problemlos anpassbar.

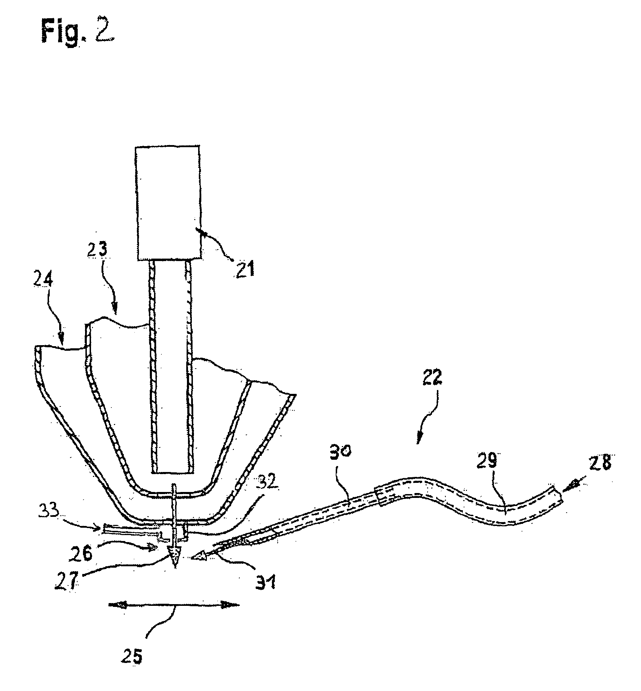

Die in Fig. 2 gezeigte Vorrichtung umfasst eine Vakuum-Elektronenstrahl-Kanone 21 mit einer separat zur Vakuum- Elektronenstrahl-Kanone 21 angeordneten Schutzgaszuführung 22 zur Abdichtung eines die Schweißnaht umgebenden Schweißbereiches gegenüber der Atmosphäre.

Die Vakuum-Elektronenstrahl-Kanone 21 weist ebenfalls zwei Unterdruckstufen 23, 24 auf und ist in Arbeitsrichtung 25 beweglich angeordnet. Durch eine Öffnung 26 tritt ein Elektronenstrahl 27 auf ein - nicht dargestelltes - zu schweißendes metallisches, beispielsweise aus Aluminium oder Stahlblech bestehendes Werkstück. Im Bereich der Öffnung 26 ist in bekannter Weise eine Einrichtung 32 zur Zuführung von Prozessgas 33 angeordnet.

Durch die separat von der Vakuum - Elektronenstrahl-Kanone 21 und zumindest längs deren Arbeitsrichtung 25 beweglich angeordnete Schutzgaszuführung 22 strömt ein in deren Gasschlauch 29 eingeleitetes Schutzgas 28 durch ein mit dem Gasschlauch 29 verbundenes Gasrohr 30 über dessen Ausströmdüse 31 in Richtung des Schweißbereichs. Der Gasschlauch 29 und das Gasrohr 30 der Schutzgaszuführung 22 bestehen aus einem kostengünstigen und gasresistenten Material.

Durch die in einem schleppenden oder stechenden Anstellwinkel zum Schweißbereich im Gasrohr 30 angeordnete Ausströmdüse 31 wird das Schutzgas 28 so in den Schweißbereich des zu schweißenden Werkstücks geleitet, dass ein Luftzutritt in den Schweißbereich während des Schweißens und somit die Oxidation der Schweißnahtoberfläche des zu schweißenden Werkstücks weitgehend unterbunden wird. Die Ausströmdüse 31 ist dabei winkelverstellbar angeordnet, und hinsichtlich ihres Anstellwinkes und ihrer Geometrie so gewählt, dass sie an die jeweilige Schweißaufgabe angepasst ist und den jeweiligen Schweißbereich optimal mit Schutzgas beaufschlagt. Hierdurch wird die Schweißqualität gegenüber Schweißungen nach dem Stande der Technik deutlich verbessert.

Durch einen mitlaufenden oder nachlaufenden Aufschmelzprozess kann die von der Vakuum-Elektronenstrahlkanone 1,21 erzeugte Schweißnaht ergänzend bearbeitet und etwaige auftretende Nahtüberhöhungen und Einbrandkerben ausgeglichen werden.

Der erfindungsgemäße Einsatz von Schutzgas und Prozessgas der beschriebenen Zusammensetzungen beim Non - Vakuum - Elektronenstrahlschweißen von metallischen Werkstoffen, wie beispielsweise Aluminium oder Stahlblech, verhindert atmosphärische Störeinflüsse im Schweißbereich des zu schweißenden Werkstücks und somit eine die Schweißqualität des zu schweißenden Werkstücks vermindernde Oxidation der Schweißnahtoberfläche und Einbrandkerben. Ein weiterer wesentlicher Vorteil der Erfindung besteht darin, dass das äußere Schweißnahtbild hinsichtlich der Nahtgeometrie und die Schweißnahtqualität durch Verringerung des Porenanteils wesentlich verbessert werden.

## Patentansprüche

1. Verfahren zum Non - Vakuum - Elektronenstrahlschweißen von metallischen Werkstoffen mit einer Vakuum-Elektronenkanone (1,21) und unter Einsatz von Prozessgas (33),
wobei zusätzlich zum Prozessgas (33) mindestens ein Schutzgas (11,28) als Sekundärgas zumindest gleichzeitig mit dem Prozessgas (33) eingesetzt wird, wobei das Prozessgas (33) als ein den Elektronenstrahl (7) umhüllender Prozessgasstrahl und das Schutzgas (11,28) als ein den Prozessgasstrahl umhüllender Gasstrahl eingesetzt wird, **dadurch gekennzeichnet, dass**
das Schutzgas (11,28) Argon, Helium und einen Stickstoffanteil von 0,01 bis 75 Vol.-% und das Prozessgas die Bestandteile Helium und Stickstoff, mit einem Stickstoffanteil von 40 bis 80 Vol.-% enthält.

2. Verfahren nach Anspruch 1, **dadurch gekennzeichnet, dass** das Schutzgas (11,28) kontinuierlich eingesetzt wird.

3. Verfahren nach einem der Ansprüche 1 oder 2, **dadurch gekennzeichnet, dass** das Schutzgas (11,28) gepulst eingesetzt wird.

4. Verfahren nach einem der vorhergehenden Ansprüche, **dadurch gekennzeichnet, dass** das Schutzgas (11,28) einen Sauerstoffanteil von 0,02 bis 25 Vol.-% enthält.

5. Verfahren nach einem der vorhergehenden Ansprüche,**dadurch gekennzeichnet, dass** das Prozessgas (33) bis zu 20 Vol.-% Wasserstoff und/oder bis zu 25 Vol.-% Sauerstoff enthält.

6. Verfahren nach einem der vorhergehenden Ansprüche, **dadurch gekennzeichnet, dass** beim Einsatz der Vakuum- Elektronenstrahlkanone (1,21) ein mitlaufender oder nachlaufender Aufschmelzprozess durchgeführt wird.

7. Verfahren nach Anspruch 6, **dadurch gekennzeichnet, dass** beim Aufschmelzprozess ein Schweißverfahren, etwa ein WIG-, Plasma- und/oder Laser-Schweißverfahren zum Einsatz kommt.

## Claims

1. Method for non-vacuum electron beam welding of metallic materials using a vacuum electron gun (1, 21) and using process gas (33), wherein in addition to the process gas (33) at least one shielding gas (11, 28) is used as secondary gas at least simultaneously with the process gas (33), wherein the process gas (33) is used as a process gas jet which sheaths the electron beam (7), and the shielding gas (11, 28) is used as a gas jet which sheaths the process gas jet, **characterized in that** the shielding gas (11, 28) contains argon, helium and a nitrogen content of from 0,01 to 75% by volume and the process gas contains the constituents helium and nitrogen with a nitrogen content of from 40 to 80% by volume.

2. Method according to Claim 1, **characterized in that** the shielding gas (11, 28) is used continuously.

3. Method according to one of Claims 1 or 2, **characterized in that** the shielding gas (11, 28) is used in pulsed fashion.

4. Method according to one of the preceding claims, **characterized in that** the shielding gas (11, 28) contains an oxygen content of from 0.02 to 25% by volume.

5. Method according to one of the preceding claims, **characterized in that** the process gas (33) contains up to 20% by volume of hydrogen and/or up to 25% by volume of oxygen.

6. Method according to one of the preceding claims, **characterized in that** a concomitant or trailing fusion process is carried out when the vacuum electron beam gun (1, 21) is in use.

7. Method according to Claim 6, **characterized in that** a welding process, for example a TIG, plasma and/or laser welding process, is used in the fusion process.

## Revendications

1. Procédé de soudage par faisceau d'électrons sans vide de matériaux métalliques avec un canon à électrons sous vide (1, 21) et avec utilisation d'un gaz de traitement (33), dans lequel on utilise en plus du gaz de traitement (33) au moins un gaz de protection (11, 28) comme gaz secondaire au moins en même temps que le gaz de traitement (33), dans lequel on utilise le gaz de traitement (33) comme un jet de gaz de traitement enveloppant le faisceau d'électrons (7) et le gaz de protection (11, 28) comme un jet de gaz enveloppant le jet de gaz de traitement, **caractérisé en ce que** le gaz de protection (11, 28) contient de l'argon, de l'hélium et une proportion d'azote de 0,01 à 75 % en volume et le gaz de traitement contient les composants hélium et azote, avec une proportion d'azote de 40 à 80 % en volume.

2. Procédé selon la revendication 1, **caractérisé en ce que** l'on utilise le gaz de protection (11, 28) de façon continue.

3. Procédé selon l'une quelconque des revendications 1 ou 2, **caractérisé en ce que** l'on utilise le gaz de protection (11, 28) de façon pulsée.

4. Procédé selon l'une quelconque des revendications précédentes, **caractérisé en ce que** le gaz de protection (11, 28) contient une proportion d'oxygène de 0,02 à 25 % en volume.

5. Procédé selon l'une quelconque des revendications précédentes, **caractérisé en ce que** le gaz de traitement (33) contient jusque 20 % en volume d'hydrogène et/ou jusque 25 % en volume d'oxygène.

6. Procédé selon l'une quelconque des revendications précédentes, **caractérisé en ce que** l'on exécute un processus de fusion simultané ou consécutif lors de l'utilisation du canon à faisceau d'électrons sous vide (1, 21).

7. Procédé selon la revendication 6, **caractérisé en ce que** l'on utilise lors du processus de fusion un procédé de soudage, par exemple un procédé de soudage WIG, au plasma et/ou au laser.
